Europäisches Patentamt

European Patent Office

Office européen des brevets

(19)

(11) Numéro de publication: **0 397 539**
**A1**

## (12) DEMANDE DE BREVET EUROPEEN

(21) Numéro de dépôt: 90400616.0

(51) Int. Cl.5: **G06K 11/14**

(22) Date de dépôt: **07.03.90**

(30) Priorité: **09.03.89 FR 8903074**

(43) Date de publication de la demande:
**14.11.90 Bulletin 90/46**

(84) Etats contractants désignés:
**DE GB IT NL**

(71) Demandeur: **ETAT-FRANCAIS représenté par le DELEGUE GENERAL POUR L'ARMEMENT (DPAG)**
**Bureau des Brevets et Inventions de la Délégation Générale pour l'Armement 26, Boulevard Victor**
**F-75996 Paris Armées(FR)**

(72) Inventeur: **Dieulesaint, Eugène**
**2, Av. Francis Berthier**
**F-94100 St. Maur(FR)**
Inventeur: **Legras, Olivier**
**33, Av. du Pdt Roosevelt**
**F-77100 Meaux(FR)**
Inventeur: **Royer, Daniel**
**11, Rue E. Branly**
**F-91700 Ste Geneviève des Bois(FR)**

(54) **Ecran tactile à ondes élastiques guidées à boucle oscillante.**

(57) L'écran tactile à ondes élastiques guidées, comprend une plaque (100), un dispositif transducteur (10) d'émission d'ondes élastiques dans des zones parallèles (X1 à X4) de la plaque (100), et un dispositif transducteur (30) de réception d'ondes élastiques comprenant plusieurs transducteurs recepteurs élémentaires indépendants (31 à 34). Des moyens electroniques d'excitation du dispositif d'émission (10) et des moyens électroniques de traitement des signaux délivrés par le dispositif de réception (20), comprennent un amplificateur (110) pour alimenter le dispositif d'emission (10), et un multiplexeur (130) pour connecter successivement chaque transducteur recepteur élémentaire (31 à 34) à l'entrée de l'amplificateur (110). Le gain de l'amplificateur (110) est choisi de manière à créer successivement des boucles oscillantes fermées avec plusieurs lignes à retard définies entre le dispositif d'émission (10) et le dispositif de réception (30) par les zones (X1 a X4) de la plaque (100) et des moyens sont prévus pour détecter une absence d'oscillations (4) dans les boucles formaes successivement et identifier ainsi une zone (106) ayant fait l'objet d'un contact par un doigt

FIG.1

Xerox Copy Centre

## Ecran tactile à ondes élastiques guidées à boucle oscillante.

La présente invention a pour objet un écran tactile à ondes élastiques guidées, comprenant une plaque, un premier dispositif transducteur d'émission d'ondes élastiques disposé sur un premier côté de la plaque pour émettre une pluralité de faisceaux d'ondes élastiques dans des premières zones parallèles de la plaque selon une première direction $X'X$, un premier dispositif transducteur de réception d'ondes élastiques disposé sur un second côté de la plaque opposé audit premier côté, des moyens électroniques d'excitation du premier dispositif transducteur d'émission d'ondes élastiques et des moyens électroniques de traitement des signaux délivrés par le premier dispositif transducteur de réception d'ondes élastiques (pour détecter des modifications dans la transmission des ondes élastiques au sein de la plaque et identifier une première zone de la plaque ayant fait l'objet d'un contact par un doigt.

Les organes de liaison couramment utilisés actuellement pour permettre à l'homme de communiquer avec un ordinateur comprennent un clavier, une "souris" et le cas échéant une table pour saisie de graphiques. De tels dispositifs ne se prêtent pas facilement au choix, par l'opérateur, d'une fonction parmi d'autres présentées sous la forme d'un menu. Un clavier nécessite en effet l'utilisation d'une combinaison de touches et implique une certaine dextérité et habitude de la part de l'utilisateur. Le mouvement d'une souris est lui-même conditionné par l'état de la surface du support. Une table graphique implique l'utilisation d'un organe intermédiaire tel qu'un crayon optique ou piézoélectrique que l'on doit déplacer sur la table.

Il existe ainsi un besoin de dispositifs capables d'améliorer le dialogue homme-machine et plus particulièrement de dispositifs permettant, autant que possible, d'utiliser comme organe direct de transmission d'ordre, le propre doigt de l'opérateur.

On a déjà proposé de réaliser des panneaux ou écrans à commande tactile à l'aide desquels il est possible de faire exécuter par un dispositif donné, tel qu'un calculateur, une fonction choisie parmi d'autres, en touchant du doigt la case correspondante d'un "menu" présenté sur le panneau ou l'écran.

Selon un dispositif connu de ce type, on utilise un double réseau de diodes émettrices et réceptrices de rayonnement infrarouge qui sont disposées de part et d'autre d'un écran de visualisation sur lequel est proposé un menu, suivant deux directions perpendiculaires entre elles. Le doigt de l'opérateur venant désigner une zone de l'écran coupe deux faisceaux lumineux perpendiculaires dont l'extinction indique la partie sélectionnée du menu présenté dans un ensemble de cases. Un tel dispositif ne donne pas toute satisfaction car il n'est pas indispensable de réaliser un contact mécanique du doigt avec l'écran, ce qui rend le dispositif sensible à des déclenchements intempestifs par exemple par le passage de petits objets déplacés involontairement devant l'écran.

On connait également des écrans tactiles de type capacitif comprenant deux membranes pouvant être transparentes sur lesquelles sont déposées des électrodes pouvant également être transparentes. Avec de tels types d'écrans, la résolution reste limitée et il est difficile d'obtenir une bonne qualité de transparence qui permette une bonne lecture des informations ou graphiques affichés sur l'écran classique auquel doit être superposé l'écran tactile. Un tel écran tactile reste par ailleurs assez sensible aux conditions d'environnement dans lequel il est placé.

On a encore proposé des dispositifs formant écrans tactiles à ondes de pression. Dans ce cas, la surface d'un écran d'affichage est recouverte d'un revêtement en matériau plastique dans lequel on a incrusté un conduit en serpentin qui est transparent et rempli d'air. Des capteurs de pression disposés aux extrémités du serpentin permettent la détection des ondes de pression créées lorsqu'une pression est exercée en un point du conduit. Un tel type de dispositif est de réalisation complexe et affecte également la visibilité de l'écran d'affichage auquel il est superposé.

On connait encore des écrans tactiles utilisant une plaque de matière plastique dure soutenue en chacun de ses quatre sommets par une jauge de contrainte. De tels types d'écrans sont toutefois d'un montage assez délicat.

Il a par ailleurs été proposé, notamment par le brevet US-A-3 673 327, de réaliser des écrans tactiles basés sur l'atténuation, dans une plaque de verre, d'ondes acoustiques de surface, ou ondes de Rayleigh, en ligne ouverte, lorsqu'une pression est exercée sur la plaque de verre avec un doigt. Selon d'autres réalisations de ce type, décrites notamment dans les brevets US-A-4 642 423, US-A-4 644 100, US-A-4 645 870 et US-A-4 700 176, il est proposé un écran tactile comportant une plaque transparente munie de réseaux de traits réflecteurs dans laquelle se propagent des ondes de Rayleigh dont on détecte l'atténuation due à une pression ponctuelle par le doigt en un point de la plaque.

Les divers types d'écrans tactiles à ondes de Rayleigh restent sensibles à l'état de la surface de l'écran et sont susceptibles de présenter des difficultés de mise en oeuvre dans des environnements peu préservés, du fait de la présence de poussière ou d'humidité par exemple, lorsque l'on veut détecter une atténuation de ces ondes.

La présente invention vise à remédier aux inconvénients précités et à réaliser un écran tactile dont la fiabilité, la facilité de construction et la robustesse sont améliorées par rapport aux écrans tactiles connus.

Ces buts sont atteints grâce à un écran tactile à ondes élastiquesguidées du type défini en tête de la description, caractérisé en ce que le premier dispositif transducteur de réception d'ondes élastiques comprend une pluralité de transducteurs récepteurs élémentaires indépendants, en ce que lesdits moyens électroniques d'excitation et lesdits moyens électroniques de traitementdes signaux comprennent un premier amplificateur pour alimenter le premier dispositif transducteur d'émission, un premier multiplexeur pour connecter successivement chaque transducteur récepteur élémentaire du premier dispositif transducteur de réception à l'entrée du premier amplificateur, en ce que le gain du premier amplificateur est choisi de manière à créer successivement des boucles oscillantes fermées avec une pluralité de n lignes à retard définies entre le premier dispositif transducteur d'émission et le premier dispositif transducteur de réception par lesdites premières zones de la plaque et en ce que des moyens sont prévus pour détecter une absence d'oscillations dans les voies de mesure successives constituées lorsque l'entrée du premier amplificateur est connectée par le premier multiplexeur successivement aux transducteurs récepteurs élémentaires.

La réalisation de boucles oscillantes fermées donne lieu à un fonctionnement par tout ou rien beaucoup plus sûr que le fonctionnement basé sur une simple variation d'amplitude. En effet, une boucle n'oscille que si, outre une condition sur l'amplitude, une condition sur la phase est satisfaite. De plus, la raideur d'un système oscillant peut être avantageusement modifiée par le gain de l'amplificateur de la boucle.

Selon un mode de réalisation préférentiel, le premier dispositif transducteur d'émission d'ondes élastiques et la plaque sont adaptés pour définir des ondes élastiques se propageant sous la forme d'ondes de Lamb.

L'utilisation d'ondes de Lamb, en modes de plaque, dont la vibration intéresse toute l'épaisseur de la plaque constituant le panneau de l'écran permet de réduire de façon drastique la sensibilité à l'état de la surface du panneau au contraire des dispositifs à ondes de Rayleigh dont la vibration ne pénètre dans la plaque que sur une profondeur légèrement supérieure à une longueur d'onde, tout en autorisant une détection sûre du fait de l'utilisation de boucles oscillantes.

Avantageusement, l'épaisseur de la plaque transparente est de l'ordre de quelques millimètres et choisie pour supporter une onde élastique se propageant suivant le mode de Lamb symétrique $S_0$ à une fréquence correspondant sensiblement au point d'inflexion de la courbe représentant la vitesse de phase en fonction du produit de la fréquence d'excitation du premier dispositif transducteur par l'épaisseur de la plaque. La plaque peut être en verre ou en une matière plastique transparente.

Les premiers dispositifs transducteurs d'émission et de réception comprennent un matériau piézoélectrique tel qu'une céramique PZT ou du niobate de lithium ou encore du tantalate de lithium.

Le premier dispositif transducteur de réception comprend n parties délimitées par des électrodes externes indépendantes présentant chacune une longueur qui correspond à la largeur de l'une desdites premières zones et qui peut être choisie par exemple de l'ordre d'environ 10 millimètres.

Le premier dispositif transducteur d'émission peut comprendre une électrode unique. Toutefois, selon un autre mode de réalisation possible, le premier dispositif transducteur d'émission comprend lui-même n parties délimitées par des électrodes indépendantes présentant chacune une longueur correspondant à la largeur de l'une desdites premières zones de manière à définir dans la plaque n lignes à retard totalement séparées, et un multiplexeur supplémentaire est interposé entre la sortie du premier amplificateur et le premier dispositif transducteur d'émission.

Afin de permettre la sélection de cases ou d'éléments d'un menu repérés selon un système de coordonnées rectangulaires, le dispositif selon l'invention comprend un second dispositif transducteur d'émission d'ondes élastiques semblable audit premier dispositif transducteur d'émission mais disposé sur un troisième côté de la plaque pour émettre une pluralité de faisceaux d'ondes élastiques dans des secondes zones parallèles de la plaque selon une seconde direction $Y'Y$ perpendiculaire à la première direction $X'X$, un second dispositif transducteur de réception d'ondes élastiques semblable audit premier dispositif transducteur de réception d'ondes élastiques mais disposé sur un quatrième côté de la plaque opposé audit troisième côté, un second amplificateur pour alimenter le second dispositif transducteur d'émission, un second multiplexeur pour connecter successivement chaque transducteur récepteur élémentaire du second dispositif transducteur deréception à l'entrée du second amplificateur, le gain du second amplificateur est choisi de manière à créer successivement des boucles oscillantes fermées avec une pluralité de m lignes à retard définies entre le second dispositif transducteur d'émission et le second dispositif transducteur de réception par lesdites secondes zones de la plaque et des moyens sont prévus pour détecter une absence d'oscillation dans les voies de mesure successives constituées lorsque l'entrée du second amplificateur est connectée par le second multiplexeur successivement aux transducteurs récepteurs élémentaires du second dispositif transducteur de réception.

Selon une variante de réalisation, les premier et second amplificateurs peuvent être constitués par un amplificateur unique dont la sortie est connectée aux premier et deuxième dispositifs transducteurs d'émission et l'entrée est reliée aux premier et deuxième dispositifs transducteurs de réception par un multiplexeur unique regroupant les premier et deuxième multiplexeurs.

Un écran tactile selon l'invention à plaque transparente peut être superposé à un dispositif d'affichage tel qu'un tube cathodique, un écran à cristaux liquides, un écran à plasma ou encore un écran à affichage électroluminescent. Toutefois, l'écran tactile selon l'invention peut être intégré au dispositif d'affichage lui-même. Ainsi, la plaque transparente peut être constituée directement par la plaque de verre d'affichage d'un tube cathodique.

L'écran tactile selon l'invention est bien adapté pour constituer un organe de commande coopérant ou non avec un écran d'affichage indépendant et remplaçant un organe périphérique traditionnel tel qu'un clavier. La plaque du dispositif formant écran tactile peut elle-même porter des informations constituant un menu prédéterminé de façon à définir un sélecteur pouvant fonctionner en l'absence de tout autre écran d'affichage, l'écran tactile à ondes élastiques guidées selon l'invention, grâce à sa fiabilité et à sa facilité de mise en oeuvre est également à même de constituer un organe capteur pouvant être utilisé dans des domaines tels que la sécurité, par exemple dans le cadre d'un système d'alarme pour la protection d'oeuvres d'art.

D'autres caractéristiques et avantages de l'invention ressortiront de la description suivante de modes particuliers de réalisation, donnée en référence aux dessins annexés sur lesquels :

- la figure 1 est une vue schématique de dessus d'un écran tactile selon un premier mode de réalisation de l'invention,

- la figure 2 est une vue de détail montrant le principe d'un dispositif de détection à ondes de Lamb comprenant une boucle oscillante conformément à l'invention,

- la figure 3 est une vue schématique de dessus d'un écran tactile selon un second mode de réalisation de l'invention, et

- la figure 4 montre des courbes représentant pour une plaque de commande notamment en verre les vitesses de phase des premiers modes symétrique $S_0$ et antisymétrique $A_0$ en fonction du produit de la fréquence d'excitation des moyens transducteurs d'émission par l'épaisseur de la plaque de commande.

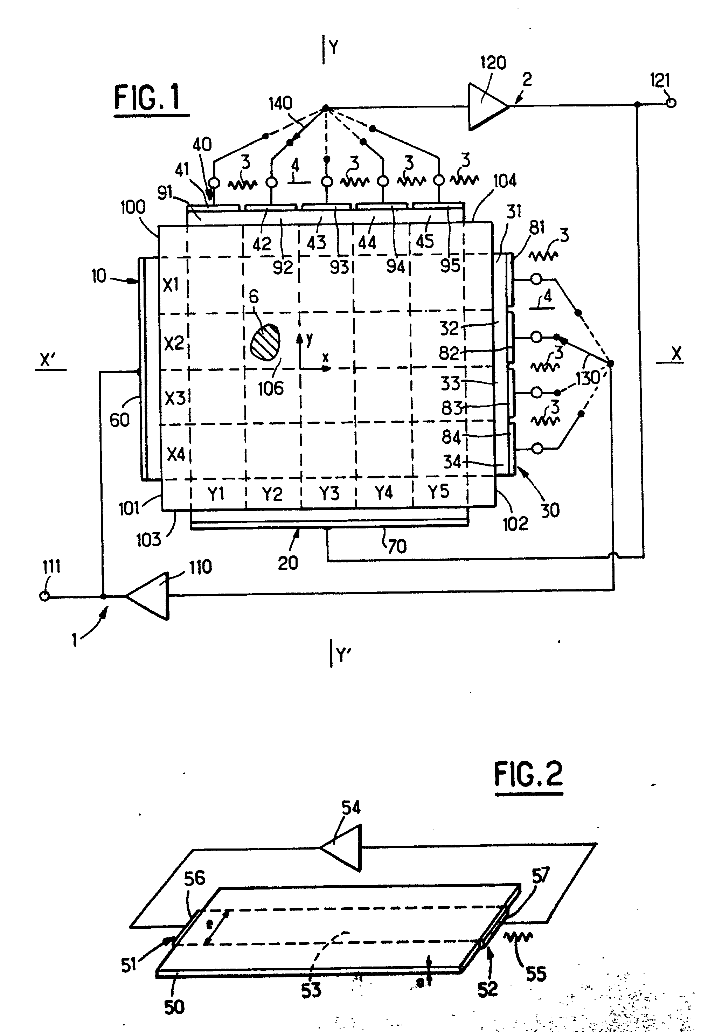

On voit sur la figure 1 une plaque 100 de forme rectangulaire, et qui pourrait être carrée, adaptée pour être superposée à ou incorporée dans un dispositif d'affichage.

La plaque 100 peut être constituée par une plaque de verre de quelques millimètres d'épaisseur, ou en une matière plastique rigide atténuant peu les ondes élastiques.

La plaque 100, qui peut être parfaitement transparente est essentiellement plane dans le cas où elle est prévue pour être superposée à un écran d'affichage plan tel que par exemple un écran à cristaux liquides, un écran au plasma ou un écran de type électroluminescent. La plaque 100 peut toutefois présenter une certaine courbure notamment si elle doit coopérer avec un dispositif d'affichage de type tube cathodique. Dans ce dernier cas, la plaque transparente 100 peut d'ailleurs être constituée directement par la plaque de verre frontale du tube cathodique formant écran d'affichage.

La plaque transparente 100 associée aux éléments qui vont être décrits ci-dessous permet de combiner à la fonction d'écran d'affichage une fonction d'écran tactile de commande permettant de faire exécuter par un dispositif, tel qu'un ordinateur ou un micro-ordinateur dont l'écran d'affichage tel qu'un tube cathodique constitue un terminal, une fonction choisie parmi d'autres, en touchant du doigt 6 la case correspondante 106 d'un menu évolutif présenté sur l'écran d'affichage à partir du dispositif de calcul ou traitement de l'information.

L'écran tactile selon l'invention, avec la plaque 100 superposée ou combinée à un écran de visualisation d'un système informatique traditionnel, constitue un organe de commande convivial qui remplace un clavier et permet à l'utilisateur de sélectionner sur l'écran de visualisation une information par un simple contact du doigt effectué sur l'écran tactile. Dans la mesure où le système informatique utilise des menus déroulants reconfigurables alphanumériques ou graphiques comportant un certain nombre d'options affichées dans des cases sur l'écran d'affichage, l'utilisateur peut, sans utiliser de clavier ni avoir des connaissances en informatique, venir simplement pointer avec son doigt la case correspondant à l'option choisie. L'emplacement de l'écran tactile sur lequel a été exercé un contact du doigt est automatiquement déterminé et les coordonnées de cet emplacement sont transmises au système informatique qui exécute immédiatement l'opération correspondant à l'option choisie avant d'afficher un nouveau menu.

L'écran tactile selon l'invention garantit une excellente fiabilité dans la reconnaissance et la localisation du contact exercé par un opérateur sur la plaque 100.

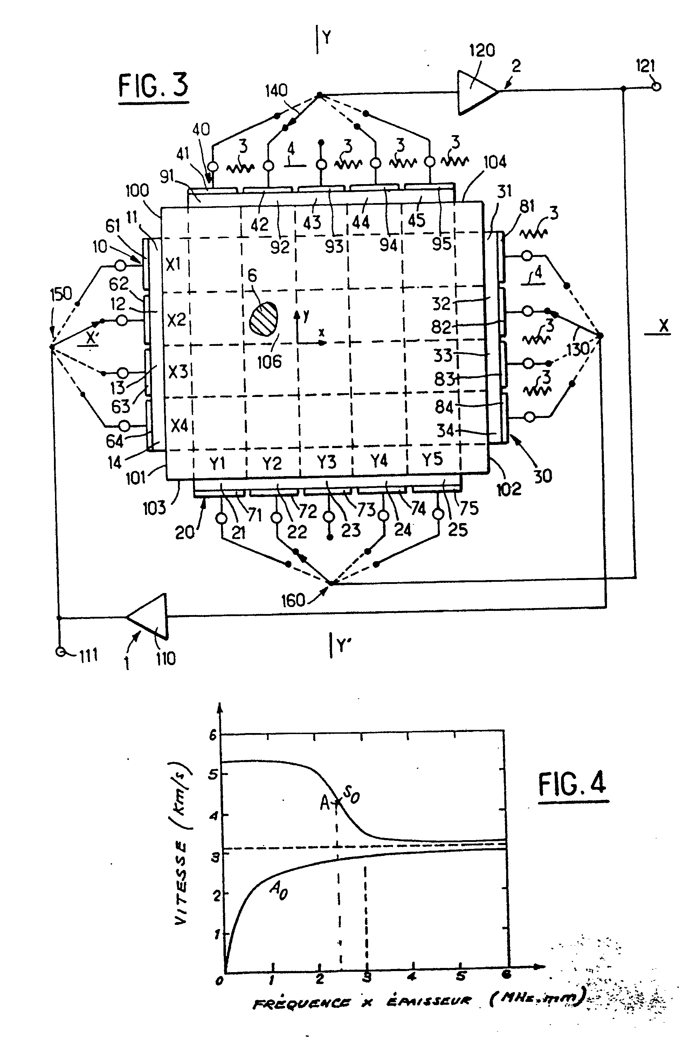

Pour cela, l'épaisseur de la plaque transparente 100, de l'ordre de quelques millimètres, est choisie pour supporter une onde élastique se propageant, de préférence suivant le mode de Lamb symétrique $S_0$ à une fréquence correspondant sensiblement au point d'inflexion A de la courbe représentant la vitesse de phase en fonction du produit de la fréquence d'excitation f des moyens transducteurs d'émission 10, 20 par l'épaisseur $\underline{a}$ de la plaque 100 (figure 4). Ce point de fonctionnement correspond aussi au minimum de la vitesse de groupe. A titre d'exemple, avec une plaque de verre ordinaire, il est possible de choisir une épaisseur $\underline{a}$ de la plaque égale à 2 mm et une fréquence d'excitation f de l'ordre de 1,3 MHz.

Bien que l'utilisation du mode de Lamb symétrique $S_0$ soit préférable, d'autres modes de propagation symétrique $S_n$ et antisymétriques $A_n$ sont aussi exploitables dans le cadre de la présente invention, de même que l'utilisation d'ondes de Rayleigh dans la mesure où notamment pour réaliser la détection des modifications de la propagation des ondes dues à un contact d'un doigt sur la plaque 100, le dispositif selon l'invention utilise des boucles oscillantes.

Le principe général de fonctionnement de l'écran tactile selon l'invention sera d'abord brièvement exposé en référence à la figure 1 qui concerne un mode particulier de réalisation utilisant des ondes de Lamb.

Un faisceau d'ondes élastiques est lancé suivant une première direction $X'X$ correspondant à une direction horizontale dans le plan de la figure 1, par un premier dispositif transducteur 10 d'émission disposé sur un premier côté 101 de la plaque 100, vers un premier dispositif transducteur de réception 30 disposé sur un second côté 102 de la plaque 100 opposé au premier côté 101. Le premier dispositif transducteur 30 de réception d'ondes élastiques comprend une pluralité n de transducteurs récepteurs élémentaires indépendants 31 à 34. De la sorte la plaque 100 apparaît comme composée de n zones parallèles horizontales X1 à X4 qui constituent des lignes à retard. Chaque ligne à retard correspondant à une voie de mesure est périodiquement mise en cascade à l'aide d'un premier multiplexeur 130 avec un premier amplificateur 110. Sur les dessins, le multiplexeur 130 a été représenté de façon symbolique de manière à faire apparaître que chaque transducteur récepteur élémentaire 31 à 34 est successivement connecté individuellement à l'entrée du premier amplificateur 110.

Le gain de l'amplificateur 110 est choisi de manière que chaque boucle constituée par d'une part une ligne à retard définie entre le dispositif transducteur d'émission 10 et le dispositif transducteur de réception 30, et d'autre part l'amplificateur 110, oscille. Lorsqu'une boucle donnée, par exemple sur la figure 1 la boucle comprenant le transducteur récepteur élémentaire 32, est sélectionnée par le multiplexeur 130, si un doigt 6 touche l'écran dans un emplacement 106 situé sur la zone X2 correspondant à la ligne à retard associée au transducteur récepteur élémentaire 32, les conditions de propagation des ondes élastiques sont localement modifiées, et en particulier il se produit une atténuation dans la ligne à retard concernée et la boucle correspondante cesse d'osciller. La détection de l'absence d'oscillation 4, grâce à des moyens de détection connectés par exemple sur la borne 111, permet d'identifier la position X2 du doigt 6 parmi les différentes zones parallèles X1 à X4 de la plaque 100.

Dans le cas où il convient de sélectionner dans la plaque 100 non pas seulement une zone parmi plusieurs zones parallèles, mais une case 106 définie par l'intersection d'une pluralité de n zones horizontales parallèles X1 à X4 et d'une pluralité de m zones verticales parallèles Y1 à Y5, il convient de mettre en oeuvre un second dispositif de détection analogue à celui qui vient d'être décrit.

Le second dispositif de détection comprend ainsi un second dispositif transducteur 20 d'émission d'ondes élastiques semblable au premier dispositif transducteur d'émission mais disposé sur un troisième côté 103 de la plaque 100 pour émettre une pluralité m d'ondes élastiques dans des secondes zones parallèles Y1 à Y5 de la plaque 100 selon une seconde direction $Y'Y$ perpendiculaire à la première direction $X'X$. Un second dispositif transducteur 40 de réception semblable au premier dispositif transducteur 30 de réception est disposé sur un quatrième côté 104 de la plaque 100 opposé au troisième côté 103. Un second amplificateur 120 semblable à l'amplificateur 110 sert à alimenter le second dispositif transducteur d'émission 20. Un second multiplexeur 140 semblable au multiplexeur 130 permet de connecter successivement chaque transducteur récepteur élémentaire 41 à 45 du dispositif transducteur de réception 40 à l'entrée du second amplificateur 120.

Le gain de l'amplificateur 120 est choisi de manière que chaque boucle constituée par d'une part une ligne à retard définie entre le dispositif transducteur d'émission 20 et le dispositif transducteur de réception 40, et d'autre part l'amplificateur 120, oscille. De la même façon que pour une détection selon la direction $X'X$, lorsqu'une boucle donnée, par exemple sur la figure 1 la boucle comprenant le transducteur récepteur élémentaire 42, est sélectionnée par le multiplexeur 140, si un doigt 6 touche l'écran dans un emplacement 106 situé sur la zone 42 correspondant à la ligne à retard associée au transducteur récepteur élémentaire 42, la boucle correspondante cesse d'osciller. La détection de l'absence d'oscillation 4, grâce à des moyens de détection connectés par exemple sur la borne 121, permet d'identifier la position Y2 du doigt 6 parmi les différentes zones parallèles Y1 à Y5 de la plaque 100.

Sur la figure 1 on a visualisé au voisinage de chaque transducteur élémentaire de réception 31 à 34, 41 à 45 des premier et second dispositifs transducteurs de réception 30, 40 l'état oscillant 3 ou non oscillant 4 de la boucle correspondante constituée lorsque la ligne à retard correspondante est mise en cascade avec le premier amplificateur 110 ou respectivement le second amplificateur 120 par l'intermédiaire du premier multiplexeur 130 ou respectivement du second multiplexeur 140. On constate que pour un contact exercé au niveau de la case 106 de coordonnées X2, Y2 correspondant à une fonction particulière désirée identifiée sur l'écran d'affichage, l'état non oscillant 4 est obtenu pour les boucles associées respectivement aux transducteurs 32 et 42 correspondant respectivement aux zones X2 et Y2.

La figure 2 vise à illustrer de façon claire la boucle oscillante formée au niveau d'une zone de détection 53 de largeur e définie, par exemple de 10 à 15 mm, dans une plaque 50 d'épaisseur a adaptée pour la transmission d'ondes élastiques selon le mode de Lamb. La plaque 50 présente une longueur par exemple de l'ordre de 150 à 300 mm correspondant à l'une des dimensions d'un écran de visualisation classique. Deux transducteurs en céramique piézoélectrique 51, 52, en forme de barreau ou de plaquette, munis chacun d'une électrode 56, 57 sont disposés aux deux extrémités de la plaque 50 qui délimitent les extrémités de la zone de détection 53 constituant une ligne à retard. Un amplificateur 54 est connecté entre l'électrode 57 du transducteur 52 qui constitue un transducteur de réception d'ondes élastiques et l'électrode 56 du transducteur 51 qui constitue un transducteur d'émission d'ondes élastiques. Le gain de l'amplificateur est ajusté en fonction des pertes de conversion des transducteurs 51, 52 pour qu'en l'absence de pression sur la plaque 50 une oscillation 55 soit produite à une fréquence f. L'oscillation est interrompue dès qu'un doigt touche la plaque 50 dans la zone 53 où se propagent les ondes de Lamb, mais réapparaît dès que le doigt est retiré. La constitution d'une boucle oscillante fermée, par les conditions de phase et d'amplitude qu'elle implique, garantit une détection d'une meilleure fiabilité que la simple détection de variations d'amplitude d'un signal résultant de l'atténuation des ondes élastiques lorsqu'un contact manuel est exercé.

Si l'on considère à nouveau la figure 1, les dispositifs transducteurs émetteurs 10, 20 peuvent être constitués par un matériau piézoélectrique, tel qu'une céramique PZT, du niobate de lithium ou encore du tantalate de lithium, associé à une électrode extérieure unique 60, 70. Chaque transducteur 10, 20 peut être composé de plusieurs barreaux ou plaquettes présentant chacun une longueur de l'ordre de 5 à 10 centimètres de manière à définir une longueur totale correspondant à la dimension du côté correspondant 101, 102 de la plaque 100. Les barreaux des transducteurs 10, 20 peuvent être collés sur le chant de la plaque 100. Toutefois, d'autres montages sont possibles, tels que par exemple un collage sur biseau ou sur la surface principale de la plaque 100, ou encore un collage sur une pièce en forme de coin, notamment dans le cas où la plaque 100 est constituée directement par la plaque de verre frontale d'un tube cathodique.

Les dimensions des transducteurs émetteurs 10, 20 autres que la longueur sont choisies en fonction du mode et de la fréquence retenus, c'est-à-dire des caractéristiques de la plaque 100.

Les transducteurs récepteurs 30, 40 peuvent être constitués à partir de barreaux ou plaquettes en matériau piézoélectrique d'une façon analogue aux transducteurs émetteurs 10, 20. Toutefois, dans le cas des dispositifs transducteurs récepteurs 30 respectivement 40, une pluralité de n respectivement m transducteurs récepteurs élémentaires indépendants 31 à 34 respectivement 41 à 45 sont définis par des électrodes externes indépendantes 81 à 84 respectivement 91 à 95. Le nombre n respectivement m de ces parties est imposé par le nombre de cases XiYj des menus devant être affichés sur l'écran d'affichage sur lequel est placée la plaque 100. Les dimensions d'une case, c'est-à-dire les largeurs des zones X1 à X4 et Y1 à Y5 peuvent être de l'ordre de 10 mm et sont définies en principe par la surface normale, de l'ordre d'un centimètre carré, d'un index.

L'indépendance de deux parties voisines telles que 31, 32 ou 41, 42 par exemple, d'un transducteur récepteur 30, 40 peut être augmentée, en cas de besoin, grâce à des sillons transversaux.

On décrira maintenant en référence à la figure 3, un second mode de réalisation de l'invention, dans lequel chacun des dispositifs transducteurs d'émission 10 respectivement 20 comprend lui-même une pluralité de n respectivement m parties délimitées par des électrodes indépendantes 61 à 64, respectivement 71 à 75, présentant chacune une longueur correspondant à la largeur de chacune des premières zones parallèles X1 à X4 respectivement de chacune des secondes zones parallèles Y1 à Y5, d'une façon semblable aux dispositifs transducteurs de réception 30 respectivement 40 correspondants. Il est ainsi défini dans la plaque 100 deux ensembles de lignes à retard totalement séparées. Dans ce cas, il convient toutefois d'insérer un multiplexeur supplémentaire 150 respectivement 160 entre la sortie de l'amplificateur 110 respectivement 120 et le dispositif transducteur d'émission correspondant 10 respectivement 20, ce multiplexeur supplémentaire 150 respectivement 160 étant synchronisé avec le multiplexeur 130 respectivement 140 coopérant avec le dispositif transducteur de réception 30 respectivement 40.

Comme on l'a déjà indiqué, le gain des amplificateurs 110, 120 est réglé pour que les boucles successives qu'ils forment avec les lignes à retard de la plaque 100 entrent en oscillation. Ce gain dépend de la longueur de ces lignes et des pertes de conversion des transducteurs.

La fréquence de mise en oscillation de chacune des boucles est liée à leur nombre et à la durée du contact du doigt avec la plaque. Ainsi, la durée d'exploration de chaque voie de mesure définie par le multiplexeur 130 respectivement 140 est de l'ordre de la durée moyenne d'un contact manuel digital sur la plaque 100 divisée par le nombre n respectivement m de zones parallèles X1 à X4 respectivement Y1 à Y5, et le nombre d'oscillations de la boucle fermée de chaque voie de mesure en l'absence de contact manuel digital est de l'ordre de préférence de plusieurs milliers, de manière à laisser au régime oscillatoire le temps de s'établir.

A titre d'exemple, si le contact d'un doigt est estimé avoir lieu pendant 0,1 seconde et si 20 voies sont à explorer pendant ce temps, le temps d'exploration de chaque voie est de 5 millisecondes et le nombre d'oscillations de chaque boucle, pour une fréquence d'oscillation f de 1MHz est de l'ordre de 5000.

Selon une variante de réalisation de l'invention, les amplificateurs 110 et 120 sont constitués par un amplificateur unique dont la sortie est connectée aux deux dispositifs transducteurs d'émission 10 et 20 et l'entrée est reliée aux premier et deuxième dispositifs transducteurs de réception 30, 40 par un multiplexeur unique regroupant les multiplexeurs 130 et 140. Dans ce cas, l'exploration des voies de mesure à l'aide du multiplexeur unique doit être plus rapide puisque l'exploration pour les directions XX' et YY' s'effectue de façon séquentielle et non en parallèle.

Si l'on utilise un amplificateur unique dans le cas du mode de réalisation de la figure 3, il convient aussi de regrouper les deux multiplexeurs 150 et 160 au sein d'un multiplexeur unique synchronisé avec le multiplexeur unique regroupant les multiplexeurs 130 et 140.

L'écran tactile selon l'invention peut comprendre une plaque transparente 100 superposée à un écran d'affichage indépendant ou constituant une partie d'un dispositif d'affichage traditionnel tel qu'un tube cathodique. Toutefois, l'écran tactile peut aussi comprendre une plaque 100 non nécessairement transparente sur laquelle sont formées directement des cases portant des symboles ou caractères alpha-numériques définissant un menu à options prédéterminées pour constituer un sélecteur indépendant.

Dans le cas où l'écran tactile comprend une plaque 100 transpatente, cet écran peut aussi être utilisé par exemple en superposition à une oeuvre d'art tel qu'un tableau, pour constituer un organe capteur permettant de déclencher une alarme en cas de détection de contacts en une ou plusieurs zones identifiables de l'écran, la reconnaissance des zones sur lesquelles se produisent des contacts pouvant être effectuée d'une manière analogue à ce qui a été décrit en référence aux figures 1 et 3.

## Revendications

1. Ecran tactile à ondes élastiques guidées, comprenant une plaque (100), un premier dispositif transducteur (10) d'émission d'ondes élastiques disposé sur un premier côté (101) de la plaque (100) pour émettre une pluralité (n) de faisceaux d'ondes élastiques dans des premières zones parallèles (X1 à X4) de la plaque (100) selon une première direction X'X, un premier dispositif transducteur (30) de réception d'ondes élastiques disposé sur un second côté (102) de la plaque (100) opposé audit premier côté (101), des moyens électroniques d'excitation du premier dispositif transducteur (10) d'émission d'ondes élastiques et des moyens électroniques de traitement des signaux délivrés par le premier dispositif transducteur (30) de réception d'ondes élastiques pour détecter des modifications dans la transmission des ondes élastiques au sein de la plaque (100) et identifier une première zone (106) de la plaque (100) ayant fait l'objet d'un contact par un doigt, caractérisé en ce que le premier dispositif transducteur (30) de réception d'ondes élastiques comprend une pluralité (n) de transducteurs récepteurs élémentaires indépendants (31 à 34), en ce que lesdits moyens électroniques d'excitation et lesdits moyens électroniques de traitement des signaux comprennent un premier amplificateur (110) pour alimenter le premier dispositif transducteur (10) d'émission, un premier multiplexeur (130) pour connecter successivement chaque transducteur récepteur élémentaire (31 à 34) du premier dispositif transducteur de réception (30) à l'entrée du premier amplificateur (110), en ce que le gain du premier amplificateur (110) est choisi de manière à créer successivement des boucles oscillantes fermées avec une pluralité de n lignes à retard définies entre le premier dispositif transducteur d'émission (10) et le premier dispositif transducteur de réception (30) par lesdites premières zones (X1 à X4) de la plaque (100) et en ce que des moyens sont prévus pour détecter une absence d'oscillations (4) dans les voies de mesure (successives constituées lorsque l'entrée du premier amplificateur (110) est connectée par le premier multiplexeur (130) successivement aux transducteurs récepteurs élémentaires (31 à 34).

2. Ecran tactile selon la revendication 1, caractérisé en ce que le premier dispositif transducteur (10) d'émission d'ondes élastiques et la plaque (100) sont adaptés pour définir des ondes élastiques se propageant sous la forme d'ondes de Lamb.

3. Ecran tactile selon la revendication 2, caractérisé en ce que l'épaisseur de la plaque transparente (100) est de l'ordre de quelques millimètres et choisie pour supporter une onde élastique se propageant suivant le mode de Lamb symétrique $S_0$ à une fréquence correspondant sensiblement au point d'inflexion de la courbe représentant la vitesse de phase en fonction du produit de la fréquence d'excitation (f) du premier dispositif transducteur (10) par l'épaisseur (a) de la plaque (100).

4. Ecran tactile selon l'une quelconque des revendications 1 à 3, caractérisé en ce que la plaque (100) est en verre ou en une matière plastique transparente.

5. Ecran tactile selon l'une quelconque des revendications 1 à 4, caractérisé en ce que les premiers dispositifs transducteurs d'émission (10) et de réception (30) comprennent un matériau piézoélectrique tel qu'une céramique PZT, du niobate de lithium ou encore du tantalate de lithium.

6. Ecran tactile selon l'une quelconque des revendications 1 à 5, caractérisé en ce que le premier dispositif transducteur d'émission (10) comprend un ensemble de barreaux ou plaquettes présentant chacun une longueur de l'ordre de 5 à 10 centimètres et coopérant avec une électrode unique (60).

7 Ecran tactile selon la revendication 6, caractérisé en ce que les barreaux sont collés sur le chant du premier côté (101) de la plaque (100).

8. Ecran tactile selon la revendication 5, caractérisé en ce que le premier dispositif transducteur de réception (30) comprend n parties délimitées par des électrodes externes indépendantes (81 à 84) présentant chacune une longueur qui correspond à la largeur de l'une desdites premières zones (X1 à X4).

9. Ecran tactile selon la revendication 8, caractérisé en ce que ladite longueur des électrodes externes indépendantes (81 à 84) est choisie de l'ordre de 10 millimètres.

10. Ecran tactile selon la revendication 8, caractérisé en ce que le premier dispositif transducteur de réception (30) comprend un ensemble de barreaux piézoélectriques alignés collés sur le chant du second côté (102) de la plaque (100) et dans lesquels sont formés des sillons transversaux pour délimiter les différentes parties coopérant avec des électrodes indépendantes (81 à 84) pour former des transducteurs récepteurs élémentaires indépendants (31 à 34).

11. Ecran tactile selon l'une quelconque des revendications 1 à 10, caractérisé en ce que le premier dispositif transducteur d'émission (10) comprend lui-même n parties délimitées par des électrodes indépendantes (61 à 64) présentant chacune une longueur correspondant à la largeur de l'une desdites premières zones (X1 à X4) de manière à définir dans la plaque (100) n lignes & retard totalement séparées, et en ce qu'un multiplexeur supplémentaire (150) est interposé entre la sortie du premier amplificateur (110) et le premier dispositif transducteur d'émission (10).

12. Ecran tactile selon l'une quelconque des revendications 1 à 11, caractérisé en ce que la durée d'exploration de chaque voie de mesure définie par le multiplexeur (130) est de l'ordre de la durée moyenne d'un contact manuel digital sur la plaque (100) divisée par le nombre n de premières zones parallèles (X1 à X4) et en ce que le nombre d'oscillations de la boucle fermée de chaque voie de mesure en l'absence de contact manuel digital est de l'ordre de plusieurs milliers, de manière à laisser au régime oscillatoire le temps de s'établir.

13. Ecran tactile selon l'une quelconque des revendications 1 à 12, caractérisé en ce qu'il comprend un second dispositif transducteur (20) d'émission d'ondes élastiques semblable audit premier dispositif transducteur (10) d'émission mais disposé sur un troisième côté (103) de la plaque (100) pour émettre une pluralité (m) de faisceaux d'ondes élastiques dans des secondes zones parallèles (41 à 45) de la plaque (100) selon une seconde direction Y'Y perpendiculaire à la première direction X'X, un second dispositif transducteur (40) de réception d'ondes élastiques semblable audit premier dispositiftransducteur (30) de réception d'ondes élastiques mais disposé sur un quatrième côté (104) de la plaque (100) opposé audit troisième côté (103), un second amplificateur (120) pour alimenter le second dispositif transducteur (20) d'émission, un second multiplexeur (140) pour connecter successivement chaque transducteur récepteur élémentaire (41 à 45) du second dispositif transducteur de réception (40) à l'entrée du second amplificateur (120), en ce que le gain du second amplificateur (120) est choisi de manière à créer successivement des boucles oscillantes fermées avec une pluralité de m lignes à retard définies entre le second dispositif transducteur d'émission (20) et le second dispositif transducteur de réception (40) par lesdites secondes zones (41 à 45) de la plaque (100) et en ce que des moyens sont prévus pour détecter une absence d'oscillation (4) dans les voies de mesure successives constituées lorsque l'entrée du second amplificateur (120) est connectée par le second multiplexeur (140) successivement aux transducteurs récepteurs élémentaires (41 à 45) du second dispositif transducteur de réception (40).

14. Ecran tactile selon la revendication 13, caractérisé en ce que les premier et second amplificateurs (110, 120) sont constitués par un amplificateur unique, dont la sortie est connectée aux premier et deuxième dispositifs transducteurs d'émission (10, 20) et l'entrée est reliée aux premier et deuxième dispositifs transducteurs de réception (30, 40) par un multiplexeur unique regroupant les premier et deuxième multiplexeurs (130, 140).

15. Ecran tectile selon l'une quelconque des revendications 1 à 14, caractérisé en ce qu'il est superposé à un dispositif d'affichage tel qu'un tube cathodique, un écran à cristaux liquides, un écran à plasma ou un écran à affichage électroluminescent.

16. Ecran tactile selon l'une quelconque des revendications 1 à 14, caractérisé en ce que la plaque transparente (100) est constituée directement par la plaque de verre d'affichage d'un tube cathodique et en ce que les dispositifs transducteurs d'émission (10, 20) et de réception (30, 40) comprennent des barreaux ou plaquettes piézoélectriques montés sur la surface principale de la plaque (100) par l'intermédiaire de coins.

17. Ecran tactile selon l'une quelconque des revendications 1 à 14, caractérisé en ce qu'il comprend une plaque (100) sur laquelle sont formées directement des cases portant des symboles ou caractères alpha-numériques définissant un menu à options prédéterminées pour constituer un sélecteur indépendant.

FIG.1

FIG.2

FIG. 3

FIG. 4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,A | US-A-3 673 327 (R.G. JOHNSON et al.) * Colonne 2, ligne 24 - colonne 3, ligne 20; figures 1-3 * | 1,4,5 | G 06 K 11/14 |
| A | ELECTRONICS LETTERS, vol. 23, no. 19, 10 septembre 1987, pages 982-984, Stevenage, Herts, GB; E. DIEULESAINT et al.: "Lamb wave graphic tablet" * En entier * | 1-7,10, 11,13-15 | |
| A | IEEE TRANSACTIONS ON NUCLEAR SCIENCE, vol. NS-18, no. 3, juin 1971, pages 414-417; D. FRYBERGER et al.: "An innovation in control panels for large computer control systems" * En entier * | 1,4,8, 11,13, 15,16 | |

**DOMAINES TECHNIQUES RECHERCHES (Int. Cl.5)**

G 06 K
G 10 K
G 01 B
H 03 K

Le présent rapport a été établi pour toutes les revendications

| Lieu de la recherche | Date d'achèvement de la recherche | Examinateur |
|---|---|---|
| LA HAYE | 30-08-1990 | CIARELLI N. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)